# EUROPEAN PATENT APPLICATION

(11) **EP 3 901 968 A1**
(43) Date of publication of application: **27.10.2021**
(21) Application number: 20748118.5
(22) Date of filing: 23.01.2020
(51) Int. Cl.: H01F 1/11, C01G 49/00, H01F 1/113, H05K 9/00

(54) **MAGNETOPLUMBITE-TYPE HEXAGONAL FERRITE MAGNETIC POWDER AND METHOD FOR MANUFACTURING SAME**

(30) Priority: 31.01.2019 JP 2019016006
(71) Applicant: DOWA ELECTRONICS MATERIALS CO., LTD., Chiyoda-ku Tokyo 101-0021 (JP)
(72) Inventor: YAMAJI, Hidenori, Tokyo 101-0021 (JP); GOTOH, Masahiro, Tokyo 101-0021 (JP)
(74) Representative: Manitz Finsterwald Patent- und Rechtsanwaltspartnerschaft mbB
(86) International application number: PCT/JP2020/002215
(87) International publication number: WO 2020/158554

(57) **Abstract**

There are provided a magnetoplumbite-type hexagonal crystal ferrite magnetic powder which can be suitably used as the material of a radio wave absorber having an excellent radio wave absorbing power in the 76 GHz band, and a method for producing the same. In a method for producing a magnetoplumbite-type hexagonal crystal ferrite magnetic powder, the method comprising the steps of: mixing powders of the raw materials of a magnetoplumbite-type hexagonal crystal ferrite magnetic powder, which is expressed by a compositional formula of AFe₍₁₂₋ₓ₎AlₓO₁₉ (A is at least one selected from the group consisting of Sr, Ba, Ca and Pb, x = 1.0 to 2.2), to obtain a mixture; granulating and molding the mixture to obtain molded bodies; firing the molded bodies to obtain fired bodies; and pulverizing the fired bodies, there are prepared a plurality of firing containers (firing scabbards 10), each of which has an opening of the upper face thereof and a notch (10a) formed in the upper portion of the side face thereof so as to be communicated with the outside thereof, each of the firing containers being filled with the molded bodies, and the firing containers being stacked in a plurality of stages so as to close the opening of the top face of the lower firing container, to fire the molded bodies in a firing furnace (20).

## Description

### Technical Field

The present invention relates generally to a magnetoplumbite-type hexagonal crystal ferrite magnetic powder and a method for producing the same. More specifically, the invention relates to a magnetoplumbite-type hexagonal crystal ferrite magnetic powder which can be suitably used as the material of a radio wave absorber or the like, and a method for producing the same.

### Background Art

In recent years, radio waves in GHz bands are used in various applications, such as mobile phones, wireless local area networks (LANs), satellite broadcasts, intelligent transport systems, electronic toll collection (ETC) systems and advanced cruise-assist highway systems (AHSs), in association with the highly developed information and communication technology. If such utility forms of radio waves in high frequency bands are diversified, there is a concern that breakdowns, malfunctions dysfunctions or the like may be caused by the interference between electronic parts. As one of measures against them, radio wave absorbers are used for absorbing unnecessary radio waves to prevent the reflection and absorption of the radio waves.

Particularly recently, automatic driver assistance systems are actively researched to advance the development of in-vehicle radars for detecting information, such as the distance between vehicles, by utilizing radio waves (millimeter waves) in the 76 GHz band. In association therewith, there are required the materials having an excellent radio wave absorbing power at around 76 GHz.

As a material having such a radio wave absorbing power, there is proposed a magnetic powder for radio wave absorber, wherein the magnetic powder is a magnetoplumbite-type hexagonal crystal ferrite magnetic powder which is expressed by a composition formula of AFe₍₁₂₋ₓ₎AlₓO₁₉ (wherein A is at least one of Sr, Ba, Ca and Pb, and x = 1.0 to 2.2) and wherein the peak particle diameter in the laser diffraction scattering particle size distribution thereof is not less than 10 *µ*m (see, e.g., Patent Document 1).

### Prior Art Document(s)

### Patent Document(s)

Patent Document 1: JP 2007-250823 (Paragraph Number 0011)

### Summary of the Invention

### Problem to be solved by the Invention

However, if the utility forms of radio waves (millimeter waves) in the 76 GHz band are diversified in future, it is considered that the radio wave absorbing power is insufficient even in the radio wave absorber, the material of which is the magnetic powder for radio wave absorber disclosed in Patent Document 1, so that there is desired a magnetoplumbite-type hexagonal crystal ferrite magnetic powder which can be suitably used as the material of a radio wave absorber having a more excellent radio wave absorbing power.

It is therefore an object of the present invention to eliminate the aforementioned conventional problems and to provide a magnetoplumbite-type hexagonal crystal ferrite magnetic powder which can be suitably used as the material of a radio wave absorber having an excellent radio wave absorbing power in the 76 GHz band, and a method for producing the same.

### Means for solving the Problem

In order to accomplish the aforementioned object, the inventors have diligently studied and found that it is possible to provide a magnetoplumbite-type hexagonal crystal ferrite magnetic powder which can be suitably used as the material of a radio wave absorber having an excellent radio wave absorbing power for millimeter waves in the 76 GHz band, and a method for producing the same, if the magnetoplumbite-type hexagonal crystal ferrite magnetic powder, which is expressed by a composition formula of AFe₍₁₂₋ₓ₎AlₓO₁₉ (wherein A is at least one selected from the group consisting of Sr, Ba, Ca and Pb, and x = 1.0 to 2.2), has a particle diameter D₅₀ corresponding to 50% of accumulation in volume-based cumulative distribution of the magnetic powder, the particle diameter D₅₀ being measured by means of a laser diffraction particle size analyzer and being not greater than 5 *µ*m, and has a crystalline diameter Dx which is obtained by an X-ray diffraction measurement and which is not less than 90 nm. Thus, the inventors have made the present invention.

According to the present invention, there is provided a magnetoplumbite-type hexagonal crystal ferrite magnetic powder, which is expressed by a composition formula of AFe₍₁₂₋ₓ₎AlₓO₁₉ (wherein A is at least one selected from the group consisting of Sr, Ba, Ca and Pb, and x = 1.0 to 2.2), wherein a particle diameter D₅₀ corresponding to 50% of accumulation in volume-based cumulative distribution of the magnetic powder, which is measured by means of a laser diffraction particle size analyzer, is not greater than 5 *µ*m, and wherein a crystalline diameter Dx of the magnetic powder, which is obtained by an X-ray diffraction measurement, is not less than 90 nm.

The magnetoplumbite-type hexagonal crystal ferrite magnetic powder preferably has a BET specific surface area of not greater than 2 m²/g. The product of the BET specific surface area by the particle diameter D₅₀ is preferably not greater than 5 *µ*m · m²/g. The peak particle diameter, which is a particle diameter having the highest frequency in a particle size distribution of the magnetoplumbite-type hexagonal crystal ferrite magnetic powder, is preferably not greater than 3 *µ*m.

According to the present invention, there is provided a method for producing a magnetoplumbite-type hexagonal crystal ferrite magnetic powder, the method comprising the steps of: preparing a plurality of firing containers, each of the firing containers having an opening of a top face thereof, each of the firing containers having a notch of an upper portion of a side face thereof, the notch being communicated with the outside of the firing containers; mixing powders of raw materials of a magnetoplumbite-type hexagonal crystal ferrite magnetic powder, which is expressed by a composition formula of AFe₍₁₂₋ₓ₎AlₓO₁₉ (wherein A is at least one selected from the group consisting of Sr, Ba, Ca and Pb, and x = 1.0 to 2.2), to obtain a mixture; granulating and molding the mixture to obtain molded bodies; filling the molded bodies in each of the firing containers; stacking the firing containers in multistages so as to close the opening of the top face of a lower one of the firing containers; putting the firing containers in a firing furnace; firing the molded bodies in the firing furnace to obtain fired bodies; and pulverizing the fired bodies.

In this method for producing a magnetoplumbite-type hexagonal crystal ferrite magnetic powder, the firing containers are preferably stacked in four stages or more. The powders of raw materials are preferably powders of an Sr salt, Fe₂O₃, Al₂O₃ and BaCl₂. The firing of the molded bodies is preferably carried out at a temperature of 1150 to 1400 °C. The pulverizing of the fired bodies comprises the steps of: coarsely pulverizing the fired bodies to obtain a coarsely pulverized powder; and wet pulverizing the coarsely pulverized powder. The weight (g) of Cl in the molded bodies to an internal volume (L) of the firing furnace is preferably not less than 0.25 g/L.

According to the present invention, there is provided a radio wave absorber comprising: the above-described magnetoplumbite-type hexagonal crystal ferrite magnetic powder; and a resin.

### Effects of the Invention

According to the present invention, it is possible to provide a magnetoplumbite-type hexagonal crystal ferrite magnetic powder which can be suitably used as the material of a radio wave absorber having an excellent radio wave absorbing power in the 76 GHz band, and a method for producing the same

### Brief Description of the Drawings

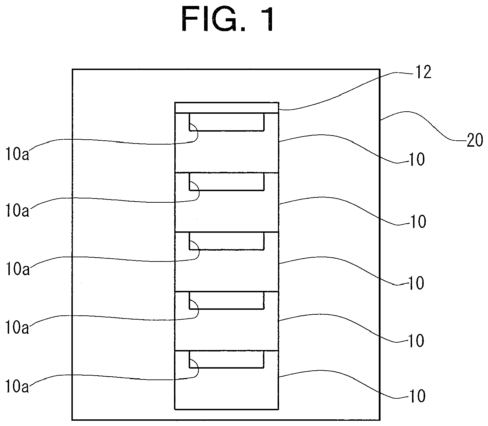

FIG. 1 is a schematic view showing a state that firing containers (firing scabbards) are stacked to be arranged in a firing furnace in the preferred embodiment of a method for producing a magnetoplumbite-type hexagonal crystal ferrite magnetic powder according to the present invention.

### Mode for Carrying Out the Invention

The preferred embodiment of a magnetoplumbite-type hexagonal crystal ferrite magnetic powder according to the present invention is expressed by a composition formula of AFe₍₁₂₋ₓ₎AlₓO₁₉ (wherein A is at least one selected from the group consisting of Sr, Ba, Ca and Pb, and x = 1.0 to 2.2 (preferably 1.3 to 2.0)), wherein a particle diameter D₅₀ corresponding to 50% of accumulation in volume-based cumulative distribution of the magnetic powder, which is measured by means of a laser diffraction particle size analyzer, is not greater than 5 *µ*m, and wherein a crystalline diameter Dx of the magnetic powder, which is obtained by an X-ray diffraction measurement, is not less than 90 nm.

Thus, if the magnetoplumbite-type hexagonal crystal ferrite magnetic powder, which is expressed by a composition formula of AFe₍₁₂₋ₓ₎AlₓO₁₉ (wherein A is at least one selected from the group consisting of Sr, Ba, Ca and Pb, and x = 1.0 to 2.2), has a particle diameter D₅₀ corresponding to 50% of accumulation in volume-based cumulative distribution of the magnetic powder, the particle diameter D₅₀ being measured by means of a laser diffraction particle size analyzer and being not greater than 5 *µ*m (preferably 1 to 5 *µ*m and more preferably 2 to 4 *µ*m), and has a crystalline diameter Dx which is obtained by an X-ray diffraction measurement and which is not less than 90 nm (preferably 90 to 180 nm and more preferably 100 to 120 nm), it is possible to produce a magnetoplumbite-type hexagonal crystal ferrite magnetic powder which can be suitably used as the material of a radio wave absorber having an excellent radio wave absorbing power for millimeter waves in the 76 GHz band. In addition, if the particle diameter D₅₀ corresponding to 50% of accumulation in volume-based cumulative distribution of the magnetic powder, which is measured by means of a laser diffraction particle size analyzer, is not greater than 5 *µ*m, it is possible to produce a thin radio wave absorber sheet using the magnetic powder.

The BET specific surface area of the magnetoplumbite-type hexagonal crystal ferrite magnetic powder is preferably not greater than 2 m²/g, and more preferably 0.5 to 2 m²/g. The product (BET x D₅₀) of the BET specific surface area by the particle diameter D₅₀ is preferably not greater than 5 *µ*m · m²/g, more preferably not greater than 4.5 *µ*m · m²/g, and most preferably 1.0 to 4.2 *µ*m · m²/g. If the product (BET x D₅₀) is not greater than 5 *µ*m · m²/g, it is possible to increase the transmission attenuation (to increase the radio wave absorbing power) of a radio wave absorber sheet using the magnetic powder while maintaining the high coercive force Hc of the magnetic powder. The peak particle diameter, (which is a particle diameter having the highest frequency) in a particle size distribution of the magnetoplumbite-type hexagonal crystal ferrite magnetic powder, is preferably not greater than 3 *µ*m, more preferably not greater than 2.5 *µ*m, and most preferably 1 to 2.5 *µ*m.

The above-described preferred embodiment of a magnetoplumbite-type hexagonal crystal ferrite magnetic powder according to the present invention can be produced by the preferred embodiment of a method for producing a magnetoplumbite-type hexagonal crystal ferrite magnetic powder according to the present invention.

The preferred embodiment of a method for producing a magnetoplumbite-type hexagonal crystal ferrite magnetic powder according to the present invention, comprises the steps of: preparing a plurality of firing containers, each of the firing containers having an opening of a top face thereof, each of the firing containers having a notch of an upper portion of a side face thereof, the notch being communicated with the outside of the firing containers; mixing powders of raw materials (preferably powders of an Sr salt, Fe₂O₃, Al₂O₃ and BaCl₂ (or BaCl₂ · 2H₂O)) of a magnetoplumbite-type hexagonal crystal ferrite magnetic powder, which is expressed by a composition formula of AFe₍₁₂₋ₓ₎AlₓO₁₉ (wherein A is at least one selected from the group consisting of Sr, Ba, Ca and Pb (preferably at least one of Sr and Ba), and x = 1.0 to 2.2 (preferably 1.3 to 2.0)), to obtain a mixture; granulating and molding the mixture to obtain molded bodies (preferably having a pellet shape); filling the molded bodies in each of the firing containers; stacking the firing containers in multistages so as to close the opening of the top face of a lower one of the firing containers; putting the firing containers in a firing furnace; firing the molded bodies (preferably at 1150 to 1400 °C) in the firing furnace to obtain fired bodies; and pulverizing the fired bodies (preferably coarsely pulverizing the fired bodies by impact pulverization or the like by means of a hammer mill or the like to obtain a coarsely pulverized powder, and then, wet pulverizing the coarsely pulverized powder). Furthermore, the content of the BaCl₂ (or BaCl₂ · 2H₂O) powder in the powders of raw materials of the magnetoplumbite-type hexagonal crystal ferrite magnetic powder is preferably 0.1 % by weight or more (when being converted into BaCl₂ in the case of BaCl₂ · 2H₂O powder) from the standpoint of the crystal growth of the magnetoplumbite-type hexagonal crystal ferrite magnetic powder. On the other hand, since it is not preferable that Cl remains in the magnetoplumbite-type hexagonal crystal ferrite magnetic powder if the content of the BaCl₂ (or BaCl₂ · 2H₂O) powder in the powders of raw materials of the magnetoplumbite-type hexagonal crystal ferrite magnetic powder is too high, the content of the BaCl₂ (or BaCl₂ · 2H₂O) powder in the powders of raw materials of the magnetoplumbite-type hexagonal crystal ferrite magnetic powder is preferably 20 % by weight or less, and more preferably in the range of from 0.5 % by weight to 10 % by weight.

Thus, if the plurality of (preferably four or more, more preferably four to twenty, or five in the preferred embodiment shown in FIG. 1) firing containers (the plurality of firing scabbards (firing dishes) 10 shown in FIG. 1), each of the firing containers having the opening of the top face thereof and having the notch of the upper portion of the side face thereof, the notch being communicated with the outside of the firing containers, are prepared to fill the molded bodies in each thereof to be stacked in multistages (preferably four or more stages, or five stages in the preferred embodiment shown in FIG. 1) so as to close the opening of the top face of the lower one of the firing containers (preferably close the opening of the top face of the uppermost firing container with a lid (a lid 12 shown in FIG. 1)), to fire the molded bodies (in multistages) in a firing furnace (a firing furnace 20 shown in FIG. 1), it is possible to produce a magnetoplumbite-type hexagonal crystal ferrite magnetic powder wherein the particle diameter D₅₀ corresponding to 50% of accumulation in volume-based cumulative distribution of the magnetic powder, which is measured by means of a laser diffraction particle size analyzer, is not greater than 5 *µ*m and wherein the crystalline diameter Dx of the magnetic powder, which is obtained by an X-ray diffraction measurement, is not less than 90 nm, so that it is possible to produce a magnetoplumbite-type hexagonal crystal ferrite magnetic powder which can be suitably used as the material of a radio wave absorber having an excellent radio wave absorbing power for millimeter waves in the 76 GHz band. Furthermore, in the preferred embodiment shown in FIG. 1, the notch of each of the firing containers is a substantially rectangular notch formed in the substantially central portion of the upper portion of the side face thereof. However, the shape of the notch should not be limited to such a shape, and may be any one of various shapes unless the notch does not reach the bottom face of the firing container. The percentage of the area of the notch to the whole area of the side face of the firing container is preferably in the range of from 3 % to 35 %, and more preferably in the range of from 10 % to 25 %, in order to produce a magnetoplumbite-type hexagonal crystal ferrite magnetic powder which can be suitably used as the material of a radio wave absorber having an excellent radio wave absorbing power in the 76 GHz band.

Thus, if the molded bodies of the powders of raw materials are fired in each of firing containers in multistages (the top of each of the firing containers being closed and being not sealed), the amount of BaCl₂ in the molded bodies to the internal volume of the firing furnace is increased (e.g., the amount of BaCl₂ is increased five times if five firing containers, in each of which the molded bodies are filled, are stacked), in comparison with a case where only one firing container, in which the molded bodies of the powders of the raw materials are filled, is arranged in a firing furnace to fire the molded bodies (in one stage). Therefore, the amount of BaCl₂ vaporized from the molded bodies at the firing temperature is increased, so that the concentration of Cl in a gas contacting the molded bodies in the firing furnace is increased. Vaporization and liquefaction are equilibrium reactions each other. Therefore, if the concentration of Cl in the gas in the firing furnace is increased, it is difficult to more vaporize the solid BaCl₂, so that the amount of BaCl₂ remaining in the molded bodies (filled in each of the firing containers) without being vaporized is increased. Thus, it is considered that this BaCl₂ effectively functions as a solution (flux) in the molded bodies, so that the crystal of the magnetoplumbite-type hexagonal crystal ferrite magnetic powder is grown to increase the crystalline diameter Dx thereof. In particular, it is considered that BaCl₂ effectively functions as the solution (flux) in the molded bodies by stacking the plurality of firing containers so as to close the opening of the top face of the lower one of the firing containers, each of which has the opening of the top face thereof and each of which has the notch of the upper portion of the side face thereof, the notch being communicated with the outside of the firing containers. Furthermore, in order to increase the concentration of Cl in the gas in the firing furnace, the weight (g) of Cl in the molded bodies of the powders of the raw materials to the internal volume (L) of the firing furnace is preferably not less than 0.25 g/L. However, considering that it is not preferable that Cl remains in the magnetoplumbite-type hexagonal crystal ferrite magnetic powder if the concentration of Cl in the gas contacting the molded bodies in the firing furnace is too high, the weight of Cl in the molded bodies of the powders of the raw materials to the internal volume (L) of the firing furnace is more preferably in the range of from 0.3 g/L to 2.5 g/L, and most preferably in the range of from 0.45 g/L to 1.8 g/L. If the opening of the top face of the uppermost firing container is closed with the lid (the lid 12 shown in FIG. 1) to fire the molded bodies in the firing furnace, an environment, to which the molded bodies in the uppermost firing container are exposed, is substantially the same as an environment, to which the molded bodies in the lower firing container are exposed, so that the magnetoplumbite-type hexagonal crystal ferrite magnetic powder produced from the fired bodies in the uppermost firing container can have substantially the same characteristics as those of the magnetoplumbite-type hexagonal crystal ferrite magnetic powder produced from the fired bodies in the lower firing container.

If the magnetoplumbite-type hexagonal crystal ferrite magnetic powder in the above-described preferred embodiment is mixed and kneaded with a resin, it is possible to produce a radio wave absorber. This radio wave absorber can have any one of various shapes in accordance with the use thereof. If a sheet-shaped radio wave absorber (a radio wave absorber sheet) is prepared, a radio wave absorber material (kneaded substance) obtained by mixing and kneading the magnetoplumbite-type hexagonal crystal ferrite magnetic powder with the resin may be rolled by means of pressure rolls so as to have a desired thickness (preferably 0.1 to 4 mm and more preferably 0.2 to 2.5 mm). The content of the magnetoplumbite-type hexagonal crystal ferrite magnetic powder in the radio wave absorber material (kneaded substance) is preferably in the range of from 70 % by weight to 95 % by weight in order to obtain a radio wave absorber having an excellent radio wave absorbing power in the 76 GHz band. The content of the resin in the radio wave absorber material (kneaded substance) is preferably in the range of from 5 % by weight to 30 % by weight in order to sufficiently disperse the magnetoplumbite-type hexagonal crystal ferrite magnetic powder in the radio wave absorber material (kneaded substance). The total content of the magnetoplumbite-type hexagonal crystal ferrite magnetic powder and the resin in the radio wave absorber material (kneaded substance) is preferably not less than 99 % by weight.

### Examples

Examples of a magnetoplumbite-type hexagonal crystal ferrite magnetic powder and a method for producing the same according to the present invention will be described below in detail.

### [Example 1]

First, 469 g of SrCO₃ (purity: 99 % by weight), 279 g of Al₂O₃ (purity: 99.9 % by weight), 2658 g of Fe₂O₃ (purity: 99 % by weight) and 93 g of BaCl₂ · 2H₂O (purity: 99 % by weight) were weighted as the powders of raw materials to be mixed by means of a Henschel mixer, and then, mixed by a dry method by means of a vibrating mill. Furthermore, the weight percentage of BaCl₂ · 2H₂O in the powders of raw materials was 2.7 % by weight. The mixed powder thus obtained was granulated and molded in a pellet shape to obtain molded bodies. Then, five firing scabbards (firing containers) (width: 310 mm, height: 100 mm, bottom area of interior: 900 cm² (= 300 mm x 300 mm), internal volume: 9000 cm³ (= 300 mm x 300 mm x 100 mm), area of substantially rectangular notch formed in the central portion of the upper portion of each of four side faces: 252 cm² (= 210 mm x 30 mm x 4)) were prepared, and 2 kg of the obtained molded bodies were filled in each of the firing scabbards. Then, as shown in FIG. 1, these firing scabbards were stacked in five stages (and the uppermost firing scabbard was closed with a lid) to be put in a box-shaped firing furnace (internal volume: 191 L), to fire the molded bodies at 1273 °C (firing temperature) for 4 hours in the atmosphere. After the fired bodies obtained by this firing were coarsely pulverized by means of a hammer mill, the coarsely pulverized powder thus obtained was wet-pulverized for 10 minutes by means of an attritor (using water as a medium). The solid-liquid separation of the slurry thus obtained was carried out, and the cake thus obtained was dried to be pulverized to obtain a magnetic powder. Furthermore, in this example and Example 2 which will be described later, the weight of Cl in the molded bodies filled in the five firing scabbards was 134.1 g, and the weight (g) of Cl in the molded bodies to the internal volume (L) of the firing furnace was 0.70 g/L.

With respect to the magnetic powder thus obtained, the BET specific surface area and particle size distribution thereof were obtained, and the X-ray diffraction (XRD) measurement thereof was carried out to obtain the crystalline diameter Dx thereof.

The BET specific surface area of the magnetic powder was measured by the single point BET method by means of a specific surface area measuring apparatus (Monosorb model-1210 produced by Mountech Co. Ltd.). As a result, the BET specific surface area of the magnetic powder was 1.49 m²/g.

The particle size distribution of the magnetic powder was measured by dry dispersion at a dispersing pressure of 1.7 bar by means of a laser diffraction particle size analyzer (HELOS particle size analyzer (HELOS & RODOS) produced by JEOL Ltd.), to obtain a particle diameter D₅₀ corresponding to 50 % of accumulation in volume-based cumulative distribution of the magnetic powder as an average particle diameter thereof. As a result, the particle diameter D₅₀ was 2.69 *µ*m. Assuming that a peak particle diameter was a particle diameter having the highest frequency in the particle size distribution of the magnetic powder, the peak particle diameter of the magnetic powder was 2.2 *µ*m. The product of the BET specific surface area by the particle diameter D₅₀ was 3.99 *µ*m · m²/g.

Then, a powder X-ray diffractometer (horizontal multipurpose X-ray diffractometer Ultima IV produced by Rigaku Corporation) was used for carrying out the X-ray diffraction measurement of the magnetic powder by the powder X-ray diffraction (XRD) analysis on conditions containing a CuKa radiation as a radiation source, a tube voltage of 40 kV, a tube current of 40 mA and a measuring range of 2 *θ* = 10° to 75°. As a result in this X-ray diffraction measurement, it was confirmed that the obtained magnetic powder was a magnetoplumbite-type hexagonal crystal ferrite magnetic powder. It is estimated from the feed ratio of the raw materials that the obtained magnetic powder is expressed by a composition formula of SrFe₍₁₂₋ₓ₎AlₓO₁₉ (x = 1.71, Ba is substituted for a part of Sr). These results were the same as those in Example 2 and Comparative Examples 1 through 3 which will be described later.

The crystalline diameter Dx of the magnetic powder was obtained by the Scherrer equation (Dx = K *λ* / *β* cos *θ*). In this equation, Dx denotes a crystallite diameter (angstrom), and *λ* denotes the wavelength (angstrom) of measuring X-rays, *β* denoting the broadening (rad) (expressed by a half-power band width (half peak width)) of diffracted rays based on the size of a crystallite, *θ* denoting a Bragg angle (rad) of the diffraction angle and K denoting the Scherrer constant (which is assumed as K = 0.94). Furthermore, the peak data on the (114) plane (diffraction angle 2*θ* = 34.0 to 34.8°) were used in the calculation thereof. As a result, the crystalline diameter Dx on the (114) plane of the magnetic powder was 107.7 nm.

Then, a vibrating sample magnetometer (VSM) (VSM-7P produced by Toei Industry Co., Ltd.) was used for measuring a B-H curve (magnetization curve) at an applied magnetic field of 1193 kA/m (15 kOe) to estimate the coercivity Hc, saturation magnetization σs and squareness ratio SQ of the magnetic powder as the magnetic characteristics thereof. As a result, the coercivity Hc was 3654 Oe, the saturation magnetization σs was 32.5 emu/g, and the squareness ratio SQ was 0.624.

Then, a radio wave absorber material (a kneaded substance) was prepared by mixing and kneading the obtained magnetic powder with a nitrile rubber (NBR, N215SL produced by JRS Corporation) serving as a polymeric material so that the content of the magnetic powder was 80 % by weight. Then, a radio wave absorber sheet having a thickness of 2 mm was obtained by rolling the prepared radio wave absorber material by means of pressure rolls.

With respect to the radio wave absorber sheet thus obtained, a free space measuring apparatus (produced by KEYCOM Corporation) and a vector network analyzer (ME7838A produced by Anritsu Corporation) were used for measuring the intensity of radio waves permeating the sheet by S21-parameters as the electromagnetic wave absorbing characteristics based on a free space method. As a result, the peak frequency of the radio wave absorber sheet was 77.3 GHz, and the transmission attenuation thereof was 28.0 dB.

### [Example 2]

A magnetic powder was prepared by the same method as that in Example 1, except that the firing temperature was 1284 °C. By the same methods as those in Example 1, the BET specific surface area and particle size distribution of the magnetic powder were obtained, and the X-ray diffraction (XRD) analysis of the magnetic powder was carried out for obtaining the crystalline diameter Dx thereof. As a result, the BET specific surface area of the magnetic powder was 1.43 m²/g, and the particle diameter D₅₀ thereof was 2.49 *µ*m. The product of the BET specific surface area by the particle diameter D₅₀ was 3.57 *µ*m · m²/g. The peak particle diameter of the magnetic powder was 2.2 *µ*m, and the crystalline diameter Dx thereof was 113.5 nm. By the same methods as those in Example 1, the magnetic characteristics of the magnetic powder were estimated. As a result, the coercivity Hc of the magnetic powder was 3673 Oe, the saturation magnetization σs thereof was 32.8 emu/g, and the squareness ratio SQ was 0.625.

By the same methods as those in Example 1, the magnetic powder was used for preparing a radio wave absorber sheet, and the peak frequency and transmission attenuation thereof were obtained. As a result, the peak frequency of the radio wave absorber sheet was 76.7 GHz, and the transmission attenuation thereof was 30.0 dB.

### [Comparative Example 1]

A magnetic powder was prepared by the same method as that in Example 1, except that the molded bodies obtained by the same method as that in Example 1 were filled in a single firing scabbard which was put in the box-shaped firing furnace without closing the top face of the firing scabbard, and that the firing temperature was 1150 °C . Furthermore, in this comparative example and Comparative Examples 2 and 3 which will be described later, the weight of Cl in the molded bodies filled in the firing scabbard was 26.8 g, and the weight (g) of Cl in the molded bodies to the internal volume (L) of the firing furnace was 0.14 g/L.

By the same methods as those in Example 1, the BET specific surface area and particle size distribution of the magnetic powder were obtained, and the X-ray diffraction (XRD) analysis of the magnetic powder was carried out for obtaining the crystalline diameter Dx thereof. As a result, the BET specific surface area of the magnetic powder was 2.43 m²/g, and the particle diameter D₅₀ thereof was 2.54 *µ*m. The product of the BET specific surface area by the particle diameter D₅₀ was 6.17 *µ*m · m²/g. The peak particle diameter of the magnetic powder was 2.1 *µ*m, and the crystalline diameter Dx thereof was 82.7 nm. By the same methods as those in Example 1, the magnetic characteristics of the magnetic powder were estimated. As a result, the coercivity Hc of the magnetic powder was 4365 Oe, the saturation magnetization σs thereof was 33.8 emu/g, and the squareness ratio SQ was 0.623.

By the same methods as those in Example 1, the magnetic powder was used for preparing a radio wave absorber sheet, and the peak frequency and transmission attenuation thereof were obtained. As a result, the peak frequency of the radio wave absorber sheet was 74.4 GHz, and the transmission attenuation thereof was 19.6 dB.

### [Comparative Example 2]

A magnetic powder was prepared by the same method as that in Comparative Example 1, except that the firing temperature was 1200 °C. By the same methods as those in Comparative Example 1, the BET specific surface area and particle size distribution of the magnetic powder were obtained, and the X-ray diffraction (XRD) analysis of the magnetic powder was carried out for obtaining the crystalline diameter Dx thereof. As a result, the BET specific surface area of the magnetic powder was 2.08 m²/g, and the particle diameter D₅₀ thereof was 3.22 *µ*m. The product of the BET specific surface area by the particle diameter D₅₀ was 6.70 *µ*m · m²/g. The peak particle diameter of the magnetic powder was 2.4 *µ*m, and the crystalline diameter Dx thereof was 83.3 nm. By the same methods as those in Example 1, the magnetic characteristics of the magnetic powder were estimated. As a result, the coercivity Hc of the magnetic powder was 4121 Oe, the saturation magnetization σs thereof was 33.8 emu/g, and the squareness ratio SQ was 0.632.

By the same methods as those in Example 1, the magnetic powder was used for preparing a radio wave absorber sheet, and the peak frequency and transmission attenuation thereof were obtained. As a result, the peak frequency of the radio wave absorber sheet was 75.0 GHz, and the transmission attenuation thereof was 18.9 dB.

### [Comparative Example 3]

A magnetic powder was prepared by the same method as that in Comparative Example 1, except that the firing temperature was 1273 °C. By the same methods as those in Comparative Example 1, the BET specific surface area and particle size distribution of the magnetic powder were obtained, and the X-ray diffraction (XRD) analysis of the magnetic powder was carried out for obtaining the crystalline diameter Dx thereof. As a result, the BET specific surface area of the magnetic powder was 1.70 m²/g, and the particle diameter D₅₀ thereof was 6.27 *µ*m. The product of the BET specific surface area by the particle diameter D₅₀ was 10.67 *µ*m · m²/g. The peak particle diameter of the magnetic powder was 4.4 *µ*m, and the crystalline diameter Dx thereof was 95.4 nm. By the same methods as those in Example 1, the magnetic characteristics of the magnetic powder were estimated. As a result, the coercivity Hc of the magnetic powder was 2849 Oe, the saturation magnetization σs thereof was 34.4 emu/g, and the squareness ratio SQ was 0.634.

By the same methods as those in Example 1, the magnetic powder was used for preparing a radio wave absorber sheet, and the peak frequency and transmission attenuation thereof were obtained. As a result, the peak frequency of the radio wave absorber sheet was 75.7 GHz, and the transmission attenuation thereof was 17.3 dB.

The producing conditions and characteristics of the magnetic powders obtained in these examples and comparative examples, and the characteristics of the radio wave absorber sheets obtained therein are shown in Tables 1 and 2.

**Table 1**

| | Firing | | Magnetic Powder | | | | |
|---|---|---|---|---|---|---|---|
| | Scabbards | Temp. (°C) | BET (m²/ g) | D₅₀ (µm) | BET x D₅₀ (µm · m²/g) | Peak Particle Diameter (µm) | Crystalline Diameter (nm) |
| Ex.1 | Five Stages | 1273 | 1.49 | 2.69 | 3.99 | 2 .2 | 107.7 |
| Ex.2 | Five Stages | 1284 | 1.43 | 2.49 | 3.57 | 2.2 | 113.5 |
| Comp.1 | One Stage | 1150 | 2.43 | 2.54 | 6.17 | 2. 1 | 82.7 |
| Comp.2 | One Stage | 1200 | 2.08 | 3.22 | 6.70 | 2.4 | 83.3 |
| Comp.3 | One Stage | 1273 | 1.70 | 6.27 | 10.67 | 4.4 | 95.4 |

**Table 2**

| | Magnetic Characteristics of Magnetic Powder | | | Radio Wave Absorber Sheet | |
|---|---|---|---|---|---|
| | Hc(Oe) | σs (emu/g) | SQ | Peak Frequency (GHz) | Transmission Attenuation (dB) |
| Ex.1 | 3654 | 32.5 | 0.624 | 77.3 | 28.0 |
| Ex.2 | 3673 | 32.8 | 0.625 | 76.7 | 30.0 |
| Comp.1 | 4365 | 33.8 | 0.623 | 74.4 | 19.6 |
| Comp.2 | 4121 | 33.8 | 0.632 | 75.0 | 18.9 |
| Comp.3 | 2849 | 34.4 | 0.634 | 75.7 | 17.3 |

### Industrial Applicability

The magnetoplumbite-type hexagonal crystal ferrite magnetic powder according to the present invention can be utilized for preparing a radio wave absorber sheet having an excellent radio wave absorbing power in the 76 GHz band.

### Description of Reference Numbers

- 10: Firing Scabbard
- 10a: Notch
- 12: Lid
- 20: Box-shaped Firing Furnace

## Claims

1. A magnetoplumbite-type hexagonal crystal ferrite magnetic powder, which is expressed by a composition formula of AFe₍₁₂₋ₓ₎AlₓO₁₉ (wherein A is at least one selected from the group consisting of Sr, Ba, Ca and Pb, and x = 1.0 to 2.2),
wherein a particle diameter D₅₀ corresponding to 50% of accumulation in volume-based cumulative distribution of the magnetic powder, which is measured by means of a laser diffraction particle size analyzer, is not greater than 5 *µ*m, and
wherein a crystalline diameter Dx of the magnetic powder, which is obtained by an X-ray diffraction measurement, is not less than 90 nm.

2. A magnetoplumbite-type hexagonal crystal ferrite magnetic powder as set forth in claim 1, wherein the magnetoplumbite-type hexagonal crystal ferrite magnetic powder has a BET specific surface area of not greater than 2 m²/g.

3. A magnetoplumbite-type hexagonal crystal ferrite magnetic powder as set forth in claim 1, wherein a product of the BET specific surface area by the particle diameter D₅₀ is not greater than 5 *µ*m · m²/g.

4. A magnetoplumbite-type hexagonal crystal ferrite magnetic powder as set forth in claim 1, wherein a peak particle diameter, which is a particle diameter having the highest frequency in a particle size distribution of the magnetoplumbite-type hexagonal crystal ferrite magnetic powder, is not greater than 3 *µ*m.

5. A method for producing a magnetoplumbite-type hexagonal crystal ferrite magnetic powder, the method comprising the steps of:
preparing a plurality of firing containers, each of the firing containers having an opening of a top face thereof, each of the firing containers having a notch of an upper portion of a side face thereof, the notch being communicated with the outside of the firing containers;
mixing powders of raw materials of a magnetoplumbite-type hexagonal crystal ferrite magnetic powder, which is expressed by a composition formula of AFe₍₁₂₋ₓ₎AlₓO₁₉ (wherein A is at least one selected from the group consisting of Sr, Ba, Ca and Pb, and x = 1.0 to 2.2), to obtain a mixture;
granulating and molding the mixture to obtain molded bodies;
filling the molded bodies in each of the firing containers;
stacking the firing containers in multistages so as to close the opening of the top face of a lower one of the firing containers;
putting the firing containers in a firing furnace;
firing the molded bodies in the firing furnace to obtain fired bodies; and
pulverizing the fired bodies.

6. A method for producing a magnetoplumbite-type hexagonal crystal ferrite magnetic powder as set forth in claim 5, wherein the firing containers are stacked in four stages or more.

7. A method for producing a magnetoplumbite-type hexagonal crystal ferrite magnetic powder as set forth in claim 5, wherein said powders of raw materials are powders of an Sr salt, Fe₂O₃, Al₂O₃ and BaCl₂.

8. A method for producing a magnetoplumbite-type hexagonal crystal ferrite magnetic powder as set forth in claim 5, wherein said firing of the molded bodies is carried out at a temperature of 1150 to 1400 °C.

9. A method for producing a magnetoplumbite-type hexagonal crystal ferrite magnetic powder as set forth in claim 5, wherein said pulverizing of the fired bodies comprises the steps of:
coarsely pulverizing the fired bodies to obtain a coarsely pulverized powder; and
wet pulverizing the coarsely pulverized powder.

10. A method for producing a magnetoplumbite-type hexagonal crystal ferrite magnetic powder as set forth in claim 5, wherein a weight (g) of Cl in said molded bodies to an internal volume (L) of said firing furnace is not less than 0.25 g/L.

11. A radio wave absorber comprising: a magnetoplumbite-type hexagonal crystal ferrite magnetic powder as set forth in claim 1; and a resin.
